# DEMANDE DE BREVET EUROPEEN

(11) **EP 1 494 273 A1**
(43) Date de publication de la demande: **05.01.2005**
(21) Numéro de dépôt: 04300411.8
(22) Date de dépôt: 29.06.2004
(51) Int. Cl.: H01L 21/321, H01L 21/265, H01L 21/336, H01L 21/8238

(54) **Procédé d'oxydation de silicium**

(30) Priorité: 30.06.2003 FR 0350276
(71) Demandeur: ST MICROELECTRONICS S.A., 92120 Montrouge (FR)
(72) Inventeur: LENOBLE, Damien, 38000, GRENOBLE (FR)
(74) Mandataire: de Beaumont, Michel

(57) **Abrégé**

L'invention concerne un procédé de formation, par oxydation thermique, d'une couche d'oxyde de silicium sur un circuit intégré comportant des motifs tridimensionnels en silicium, comportant les étapes suivantes :
implanter un premier élément selon un premier angle par rapport à l'horizontale, le premier élément étant neutre électriquement et ayant un premier effet sur la vitesse de croissance d'un oxyde thermique sur du silicium ;
implanter un second élément selon un second angle par rapport à l'horizontale, le second élément étant neutre électriquement et ayant un second effet complémentaire du premier effet sur la vitesse de croissance d'un oxyde thermique sur du silicium, le second angle étant distinct du premier angle, et l'un des premier et second angles étant un angle droit ; et
procéder à une oxydation thermique du silicium.

## Description

La présente invention concerne, de façon générale, la fabrication de circuits intégrés. Plus précisément, la présente invention concerne un procédé d'oxydation de motifs tridimensionnels en silicium de très faibles dimensions.

Par motifs de très faibles dimensions, on entend ci-après des éléments en relief, dont au moins une dimension - largeur ou longueur - est inférieure à 100 nm. On considère ci-après, à titre d'exemple non-limitatif de tels motifs tridimensionnels, des grilles isolées de transistors de type MOS, la longueur des grilles étant inférieure à 100 nm.

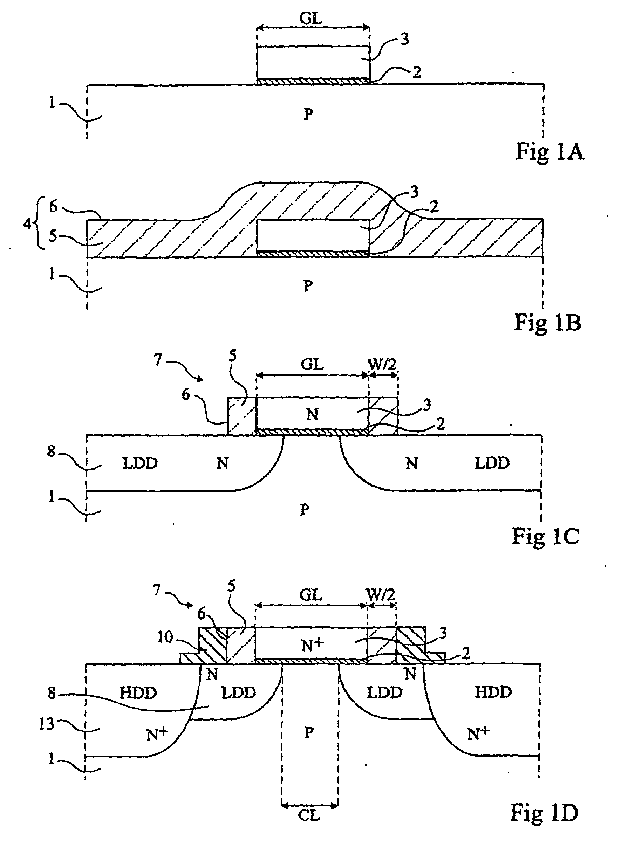

Les figures 1A à 1D illustrent, en vue en coupe schématique et partielle, différentes étapes d'un procédé de formation connu d'un transistor MOS dans un substrat 1 de silicium monocristallin, dopé de type P.

Comme l'illustre la figure 1A, on commence par former une couche isolante mince 2 puis déposer une couche de silicium polycristallin 3. Les couches 3 et 2 sont ensuite successivement gravées selon un même motif, de façon à définir la grille isolée du transistor. La grille 2-3 est définie de façon à présenter une longueur GL d'au plus 100 nm.

Aux étapes suivantes, illustrées en figure 1B, on forme une couche isolante, généralement un multicouche 4 comportant une partie interne 5 en oxyde de silicium (SiO₂) et une partie externe 6 de nitrure de silicium (Si₃N₄). La partie interne 5 résulte généralement d'une oxydation thermique du silicium constituant l'électrode de grille 3 suivie d'un dépôt d'une couche d'oxyde de silicium. La partie externe 6 résulte du dépôt d'une couche de nitrure de silicium.

Ensuite, comme l'illustre la figure 1C, on grave de façon anisotrope le multicouche 4 de façon à ne le laisser en place que sur les flancs de la grille 2-3. On forme ainsi des premiers espaceurs 7, dits de décalage (offset), qui étendent la longueur de grille GL d'une valeur w. Les espaceurs 7 servent ensuite de masque lors de la formation, dans le substrat 1, de régions 8 de source/drain faiblement dopées (LDD) par implantation de dopants de type N. Les contraintes résultant de la formation des premiers espaceurs 7 et leur rôle seront discutés ultérieurement.

Aux étapes suivantes, illustrées en figure 1D, on dépose au moins une couche isolante que l'on grave de façon anisotrope, de sorte que des seconds espaceurs 10 sont formés de part et d'autre de la grille 2-3. Ensuite, on forme, dans les régions LDD 8, par implantation/diffusion des régions 13 de source/drain fortement dopées (HDD) de type N. Lors de cette implantation, les espaceurs 10 servent de masque.

Un tel procédé et les structures résultantes présentent des inconvénients liés aux espaceurs de décalage 7.

Dans des technologies à faible longueur de grille (GL<100 nm), les premiers espaceurs évitent que les régions LDD 8 se rejoignent dans la partie du substrat 1 sous-jacente à la grille isolée 2-3. Ce risque est important du fait que la réalisation de régions LDD 8 d'une profondeur de jonction d'au plus 20 nm est délicate.

La formation des premiers espaceurs 7 résulte d'un compromis entre diverses contraintes. En particulier, les espaceurs 7 doivent avoir une longueur w/2 déterminée avec précision, inférieure à 20 nm, de préférence de l'ordre de 5 à 10 nm. Si la longueur w/2 est trop faible, il y a recouvrement entre les deux régions LDD 8 et les source et drain du transistor sont court-circuités. Inversement, si la longueur w/2 est trop importante, la longueur CL du canal est trop grande et le transistor présente des performances électriques faibles, notamment une résistance à l'état passant élevée.

La précision souhaitée ne peut être obtenue avec le procédé des figures 1A à 1C, notamment car la longueur w/2 dépend des procédés de gravure anisotrope utilisés (figures 1B-C) pour définir les espaceurs 7. Ces procédés sont mal contrôlés et conduisent à la formation d'espaceurs inhomogènes. En effet, d'une part on ne sait pas retirer les parties planes du multicouche 4 sans attaquer ou surgraver ses parties verticales destinées à former les espaceurs 7. Une telle surgravure réduit la longueur w/2 des espaceurs 7 par rapport à l'épaisseur initiale du multicouche 4. Une telle surgravure n'est pas forcément symétrique pour un transistor donné et, de plus, lorsque la densité de transistors formés est importante, elle est inhomogène pour les différents transistors.

Le problème décrit précédemment pour des grilles de transistors est rencontré de façon plus générale dès que l'on souhaite former sur des motifs en silicium une couche d'oxyde mince alors que la densité des motifs est très élevée.

La présente invention vise à proposer un procédé d'oxydation de motifs en silicium qui permet de contrôler avec précision les épaisseurs d'oxyde formées sur les différentes parties des motifs.

La présente invention vise à proposer un tel procédé qui permet de contrôler les dimensions des premiers espaceurs de grilles de transistors MOS d'une longueur inférieure à 100 nm.

Pour atteindre ces objets, la présente invention prévoit un procédé de formation, par oxydation thermique, d'une couche d'oxyde de silicium sur un circuit intégré comportant des motifs tridimensionnels en silicium, comportant les étapes suivantes :
implanter un premier élément selon un premier angle par rapport à l'horizontale, le premier élément étant neutre électriquement et ayant un premier effet sur la vitesse de croissance d'un oxyde thermique sur du silicium ;
implanter un second élément selon un second angle par rapport à l'horizontale, le second élément étant neutre électriquement et ayant un second effet complémentaire du premier effet sur la vitesse de croissance d'un oxyde thermique sur du silicium, le second angle étant distinct du premier angle, et l'un des premier et second angles étant un angle droit ; et
procéder à une oxydation thermique du silicium.

Selon un mode de réalisation de la présente invention, le premier effet est un effet de ralentissement, le second effet étant un effet d'accélération.

Selon un mode de réalisation de la présente invention, le premier élément est l'azote et le second élément est l'argon.

Selon un mode de réalisation de la présente invention, l'implantation selon un angle droit est effectuée en plaçant le circuit intégré dans un plasma de l'élément à implanter.

Selon un mode de réalisation de la présente invention, les implantations des premier et second éléments sont effectuées par bombardement du circuit intégré dans un implanteur.

Selon un mode de réalisation de la présente invention, les régions des motifs et du circuit implantées comportent des concentrations des premier et/ou second éléments inférieures à 10¹⁶ at/cm³.

Selon un mode de réalisation de la présente invention, les concentrations des premier et/ou second éléments sont comprises entre 5.10¹⁴ à 3.10¹⁵ at/cm³.

Selon un mode de réalisation de la présente invention, les régions des motifs et du circuit implantées comportant les premier et/ou second éléments ont une profondeur d'au plus 5 à 30 nm.

La présente invention prévoit également un procédé de formation d'un transistor MOS dans un substrat de silicium d'un premier type de conductivité, comportant les étapes suivantes :
définir une grille isolée de silicium polycristallin sur le substrat ;
procéder à une oxydation selon l'un quelconque des modes de réalisation précédents de façon à former une couche d'oxyde silicium plus épaisse sur les flancs de la grille que sur les surfaces planes du substrat et de la grille ;
implanter un dopant du second type de conductivité, de façon à former de part et d'autre de la grille des régions de drain/source faiblement dopées ;
former des espaceurs sur les flancs de la grille ; et
implanter un dopant du second type de conductivité, de façon à former de part et d'autre de la grille des régions de drain/source fortement dopées.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D illustrent, en vue en coupe schématique et partielle, différentes étapes d'un procédé connu de fabrication d'un transistor MOS ; et
les figures 2A à 2F illustrent, en vue en coupe schématique et partielle, différentes étapes d'un procédé de formation d'un transistor MOS selon un mode de réalisation de la présente invention.

Par souci de clarté, les mêmes éléments ont été désignés par les mêmes références aux différentes figures, et de plus, comme cela est habituel dans la représentation des circuits intégrés, les diverses figures ne sont pas tracées à l'échelle.

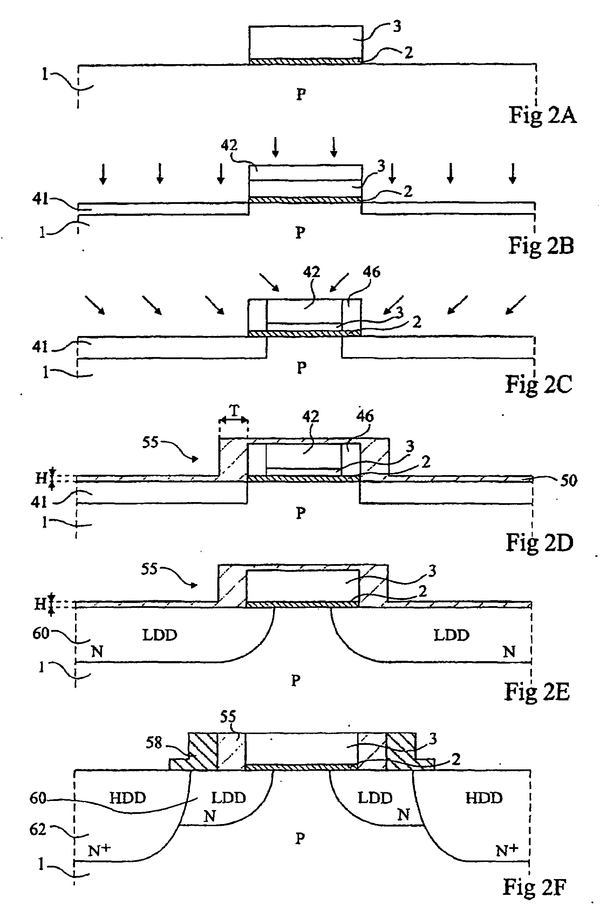

Les figures 2A à 2F illustrent, par des vues en coupe partielles et schématiques, différentes étapes d'un procédé de formation d'un transistor MOS selon un mode de réalisation de la présente invention.

Comme l'illustre la figure 2A, le procédé selon la présente invention commence par la définition de la grille isolée du transistor comprenant un isolant mince 2 et une couche de silicium polycristallin 3 sur un substrat de silicium 1 dopé d'un premier type de conductivité, par exemple de type P.

Aux étapes suivantes, illustrées en figure 2B, on procède à une implantation, selon un premier angle par rapport à l'horizontale, d'un premier élément.

Le premier angle est choisi de façon à implanter le premier élément majoritairement, sinon exclusivement, dans certaines parties données horizontales ou verticales des motifs tridimensionnels. Par exemple, le premier angle est droit. Alors, le premier élément est implanté orthogonalement, c'est-à-dire seulement dans les surfaces planes du substrat 1 et de la grille 3, les surfaces verticales, telles que les parois latérales de la grille 2-3, n'étant pas implantées. On forme ainsi des régions 41 et 42 à la surface du substrat 1 et de la grille 2-3, respectivement.

Le premier élément est choisi en fonction des deux critères suivants. En premier lieu, il doit être neutre électriquement, c'est-à-dire n'affecter ni le caractère isolant, ni le caractère conducteur, pas plus que le type de conductivité, du matériau dans lequel il est implanté. Ainsi, la région 41 demeure du type de conductivité P du substrat 1 dans lequel elle est formée. En second lieu, il doit avoir un effet donné sur la vitesse de croissance d'un oxyde thermique sur une région de silicium dans laquelle il a été implanté. Par exemple, le premier élément est de l'azote qui a un effet ralentisseur.

L'implantation est effectuée de façon que la concentration d'azote dans les régions 41 et 42 soit inférieure à 10¹⁶ atomes/cm³, de préférence de l'ordre de 5.10¹⁴ à 3.10¹⁵ atomes/cm³. En outre, les régions 41 et 42 s'étendent, depuis la surface supérieure respective du substrat 1 ou de la grille 3, sur une profondeur d'au plus 5 à 30 nm.

Aux étapes suivantes illustrées en figure 2C, on procède à une implantation d'un second élément selon un second angle par rapport à l'horizontale.

Le second élément est choisi sur la base des deux critères suivants. En premier lieu, comme le premier élément, le second élément doit être neutre électriquement. En second lieu, il doit présenter un effet complémentaire de l'effet du premier élément en termes de croissance d'oxyde. Par exemple, le second élément a un effet accélérateur de la croissance thermique de l'oxyde de silicium. Le second élément sera alors du xénon ou, de préférence, de l'argon.

Le second angle est choisi de façon à être différent du premier angle, afin d'implanter le second élément majoritairement - sinon exclusivement - dans les parties des motifs tridimensionnels ne comportant pas (ou minoritairement) le premier élément. Par exemple, l'implantation est une implantation oblique destinée à implanter l'argon majoritairement dans les flancs de la grille 2-3. Ainsi, on forme dans les flancs de la grille 2-3 des régions 46 comportant moins de 10¹⁶ atomes/cm³, de préférence de 5.10¹⁴ à 3.10¹⁵ atomes/cm³ d'argon.

A l'étape suivante, illustrée en figure 2D, on place la structure de la figure 2C dans une atmosphère oxydante et chauffée propre à provoquer la croissance d'une couche 50 d'oxyde de silicium sur les portions de silicium découvertes. Alors, la croissance de la couche d'oxyde s'effectue de façon différentielle et contrôlée. L'épaisseur de la couche 50 varie en fonction des zones 41, 42 et 46 sur lesquelles elle croît de façon prédéterminée par les concentrations en azote et argon qu'elles comportent. Dans l'exemple considéré, la couche 50 atteint une première épaisseur T sur les flancs de la grille 2-3 et une seconde épaisseur H sur les parties planes du substrat 1 et de l'électrode de grille 3, la première épaisseur T étant supérieure à la seconde épaisseur H. Les valeurs des épaisseurs T et H sont homogènes pour toutes les grilles formées sur le substrat. On forme ainsi des premiers espaceurs 55 sur les flancs de la grille 2-3 dont les dimensions sont contrôlées.

Par souci de clarté, les premier et second éléments étant neutres électriquement, les régions 41, 42 et 46 qui les contiennent ne sont plus représentées aux figures 2E et 2F.

Aux étapes suivantes, illustrées en figure 2E, on implante un dopant propre à former, de part et d'autre de la grille isolée 2-3, des régions faiblement dopées LDD de drain/source 60, par exemple de type N. A titre d'exemple non limitatif, on considère que la différence des vitesses respectives de croissance de l'oxyde sur les régions 41, 42 et sur les régions 46 est telle que l'épaisseur H des parties planes de la couche 50 est suffisamment faible, comprise entre 1 et 5 nm pour que ces parties planes puissent être maintenue en place lors de l'implantation destinée à la formation des régions LDD 60.

Ensuite, comme l'illustre la figure 2F, de façon analogue à ce qui a été décrit en relation avec la figure 1D, on retire les parties planes de la couche 50. On dépose et on grave au moins une couche isolante, par exemple une couche d'oxyde de silicium, de façon à former de part et d'autre de la grille 2-3, des seconds espaceurs 58. On implante ensuite un dopant propre à former dans le substrat 1 des régions fortement dopées (HDD) de drain/source 62, par exemple de type N.

Le procédé se poursuit par des étapes standard de formation de transistors et/ou de circuits intégrés dans un substrat semiconducteur telles que, par exemple, la formation de contacts, de métallisations et de couches de passivation.

La présente invention permet avantageusement de définir avec précision l'épaisseur T des premiers espaceurs 55. Cela permet de pallier les inconvénients décrits précédemment.

En particulier, la présente invention permet de définir avec précision l'épaisseur T même dans le cas où de très nombreux motifs tridimensionnels sont présents à la surface du circuit intégré.

Un autre avantage de la présente invention est de permettre la suppression des étapes de dépôt et de gravure liées à la formation classique des premiers espaceurs.

Bien entendu, la présente invention est susceptible de diverses variantes et modifications qui apparaîtront à l'homme de l'art. En particulier, la présente invention a été décrite dans le cas d'une oxydation différentielle des flancs d'une grille isolée en silicium polycristallin par rapport à une surface de silicium monocristallin. Toutefois, la présente invention s'applique à l'oxydation différentielle de tout motif tridimensionnel en silicium. Ainsi, le motif pourrait être une tranchée formée dans une zone de silicium monocristallin. Le procédé selon la présente invention permet alors de différentier des épaisseurs d'oxyde de silicium au fond et sur les parois de la tranchée. Le motif pourrait également être une ligne de silicium polycristallin, isolée ou non, autre qu'une grille de transistor, formée directement sur un substrat ou non.

De plus, la présente invention a été décrite dans le cas de la formation d'une couche d'oxyde de silicium plus épaisse sur les parois latérales de motifs que sur leurs surfaces planes. Toutefois, l'homme de l'art comprendra que la présente invention s'applique également aux cas dans lesquels on souhaite former une couche d'oxyde de silicium plus épaisse sur les surfaces planes de motifs que sur leurs parois latérales. On implante alors majoritairement dans les surfaces planes un élément propre à accélérer une croissance d'oxyde et on implante majoritairement dans les parois verticales un élément propre à ralentir la croissance d'oxyde.

L'homme de l'art saura également modifier les étapes décrites précédemment en fonction d'une filière technologique considérée. Ainsi, l'étape d'implantation orthogonale de la figure 2B peut être effectuée soit par un bombardement dans un implanteur, soit en plaçant le substrat 1 dans un plasma contenant l'élément neutre sous forme ionisée.

De même, on a considéré précédemment que les parties planes de la couche 50 présentent une épaisseur H suffisamment faible pour être maintenue en place lors de la formation des régions LDD 60. On notera toutefois que, selon une variante, ces parties planes peuvent être retirées avant l'implantation. L'épaisseur H étant déterminée de façon précise et homogène uniquement par les concentrations des premier et second éléments dans les régions 41 et 42 qui ne dépendent pas de la densité de transistors formés, le retrait des parties planes de la couche 50 peut être arrêté de façon plus précise que dans l'étape classique de retrait du multicouche 4 (figure 1C) dont l'épaisseur varie lorsque la densité de transistors est élevée. En outre, compte tenu de la différence existant entre les épaisseurs T et H, la gravure des parties planes de la couche 50 s'arrête avant que la surgravure de l'épaisseur T ne soit significative. En outre, un tel retrait peut alors être suivi d'une nouvelle oxydation thermique afin de former une couche mince destinée à protéger les surfaces de silicium lors du bombardement ultérieur d'implantation des dopants des régions LDD 60. Selon une autre variante, les parties planes de la couche 50 ne sont pas retirées avant la formation des espaceurs 58 mais à un stade ultérieur.

De même, l'homme de l'art comprendra que l'ordre des implantations des premier et second éléments des figures 2C-D pourrait être inversé. Ainsi, on pourrait implanter les parois verticales (figure 2C) avant d'implanter (figure 2B) les surfaces planes.

Par ailleurs, la présente invention a été décrite précédemment dans le cas de la formation de transistors à canal N. Toutefois, la présente invention s'applique également à la formation de transistors à canal P. Elle est alors tout particulièrement utile, car la diffusion du bore généralement utilisé pour former les régions LDD de type P diffuse plus dans un substrat de silicium de type N que le phosphore ou l'arsenic généralement utilisé pour former les régions LDD 60 de type N d'un transistor à canal N. Il est alors particulièrement important de pouvoir, selon un mode de réalisation de la présente invention, former des premiers espaceurs 55 suffisamment grands pour garantir une longueur de canal CL non nulle et suffisamment petits pour assurer de bonnes performances électriques au transistor résultant.

Dans le cas de filières CMOS dans lesquelles des transistors des deux types de canaux sont formés, les étapes d'implantation des premier et second éléments et d'oxydation peuvent être simultanées. Selon une variante, pour tenir compte de la diffusion plus rapide du bore, seule l'oxydation et l'implantation orthogonale, destinée à ralentir la croissance d'oxyde sur les surfaces planes, pourront être réalisées simultanément. Par contre, l'implantation oblique sera effectuée séparément pour les transistors à canal N et à canal P de façon à implanter des doses plus importantes de l'élément propre à accélérer la croissance d'oxyde dans les flancs des grilles des transistors à canal P.

En outre, on notera que par substrat on a désigné autant une tranche de silicium uniformément dopée, que des zones épitaxiées et/ou spécifiquement dopées par implantation-diffusion formées sur ou dans un substrat massif ou un substrat sur isolant (SOI).

## Revendications

1. Procédé de formation, par oxydation thermique, d'une couche d'oxyde de silicium (50) sur un circuit intégré comportant des motifs tridimensionnels en silicium, **caractérisé en ce qu'**il comporte les étapes suivantes :
implanter un premier élément selon un premier angle par rapport à l'horizontale, le premier élément étant neutre électriquement et ayant un premier effet sur la vitesse de croissance d'un oxyde thermique sur du silicium ;
implanter un second élément selon un second angle par rapport à l'horizontale, le second élément étant neutre électriquement et ayant un second effet complémentaire du premier effet sur la vitesse de croissance d'un oxyde thermique sur du silicium, le second angle étant distinct du premier angle, et l'un des premier et second angles étant un angle droit ; et
procéder à une oxydation thermique du silicium.

2. Procédé selon la revendication 1, **caractérisé en ce que** le premier effet est un effet de ralentissement, le second effet étant un effet d'accélération.

3. Procédé selon la revendication 2, **caractérisé en ce que** le premier élément est l'azote et le second élément est l'argon.

4. Procédé selon la revendication 1, **caractérisé en ce que** l'implantation selon un angle droit est effectuée en plaçant le circuit intégré dans un plasma de l'élément à implanter.

5. Procédé selon la revendication 1, **caractérisé en ce que** les implantations des premier et second éléments sont effectuées par bombardement du circuit intégré dans un implanteur.

6. Procédé selon la revendication 1, **caractérisé en ce que** les régions (41, 42, 46) des motifs et du circuit implantées comportent des concentrations des premier et/ou second éléments inférieures à 10¹⁶ at/cm³.

7. Procédé selon la revendication 6, **caractérisé en ce que** les concentrations des premier et/ou second éléments sont comprises entre 5.10¹⁴ à 3.10¹⁵ at/cm³.

8. Procédé selon la revendication 1, **caractérisé en ce que** les régions (41, 42, 46) des motifs et du circuit implantées comportant les premier et/ou second éléments ont une profondeur d'au plus 5 à 30 nm.

9. Procédé de formation d'un transistor MOS dans un substrat de silicium (1) d'un premier type de conductivité, **caractérisé en ce qu'**il comporte les étapes suivantes :
définir une grille (2-3) isolée de silicium polycristallin sur ledit substrat ;
procéder à une oxydation selon l'une quelconque des revendications 1 à 8 de façon à former une couche d'oxyde silicium (50) plus épaisse sur les flancs (46) de la grille que sur les surfaces planes (41, 42) du substrat et de la grille ;
implanter un dopant du second type de conductivité, de façon à former de part et d'autre de la grille des régions (60) de drain/source faiblement dopées (LDD) ;
former des espaceurs (58) sur les flancs de la grille; et
implanter un dopant du second type de conductivité, de façon à former de part et d'autre de la grille des régions (62) de drain/source fortement dopées (HDD).
